# EUROPEAN PATENT APPLICATION

(11) **EP 4 503 135 A1**
(43) Date of publication of application: **05.02.2025**
(21) Application number: 24190983.7
(22) Date of filing: 25.07.2024
(51) Int. Cl.: H01L 29/06, H01L 29/49, H01L 29/78, H01L 21/336

(54) **LATERALLY-DIFFUSED METAL-OXIDE SEMICONDUCTOR DEVICES WITH REDUCED GATE CHARGE AND TIME-DEPENDENT DIELECTRIC BREAKDOWN**

(30) Priority: 29.07.2023 US 202318361834
(71) Applicant: Avago Technologies International Sales Pte. Limited, Singapore 768923 (SG)
(72) Inventor: Ito, Akira, Irvine, 92618 (US)
(74) Representative: Dilg, Haeusler, Schindelmann Patentanwaltsgesellschaft mbH

(57) **Abstract**

An LDMOS with reduced gate charge and time-dependent dielectric breakdown is provided. An apparatus includes a substrate (145, 205, 305) comprising a first well (125, 215, 315) having a first doping and a second well region (130, 220, 320) having a second doping, a source (120, 255, 355) formed in the first well (125, 215, 315), and a gate (105, 240, 340) comprising an undoped block (110, 245, 345) and a doped block (115, 250, 350). The undoped block (110, 245, 345) is disposed at least partially on the source (120, 255, 355), first well (125, 215, 315), and second well (130, 220, 320). The doped block (115, 250, 350) is disposed at least partially on the second well (130, 220, 320).

## Description

### COPYRIGHT STATEMENT

A portion of the disclosure of this patent document contains material that is subject to copyright protection. The copyright owner has no objection to the facsimile reproduction by anyone of the patent document or the patent disclosure as it appears in the Patent and Trademark Office patent file or records, but otherwise reserves all copyright rights whatsoever.

### FIELD

The present disclosure relates, in general, to methods, systems, and apparatuses for gate charge and time-dependent dielectric breakdown reduction in laterally-diffused metal-oxide semiconductor (LDMOS) fin-based field-effect transistors.

### BACKGROUND

LDMOS field-effect transistors (FET) have been widely adopted as an alternative to complementary metal-oxide semiconductor (CMOS) technology for high voltage applications. The traditional figure of merit (FOM) for LDMOS performance is given as gate charge (Qg) times the drain-source on resistance (R_{DS(ON)}), or Qg * Rns(on). Conventional LDMOS structures exhibit relatively high Qg, and both split gate and conventional gate architectures suffer from hot-carrier injection (HCI) induced TDDB burnout.

Thus, methods, systems, and apparatuses for a LDMOS architecture with reduced Qg and TDDB are provided.

### BRIEF DESCRIPTION OF THE DRAWINGS

A further understanding of the nature and advantages of particular embodiments may be realized by reference to the remaining portions of the specification and the drawings, in which like reference numerals are used to refer to similar components. In some instances, a sub-label is associated with a reference numeral to denote one of multiple similar components. When reference is made to a reference numeral without specification to an existing sub-label, it is intended to refer to all such multiple similar components.
Fig. 1A is a schematic top view of a LDMOS FET with reduced Qg and TDDB, in accordance with various embodiments;
Fig. 1B is a schematic top view of an alternative LDMOS FET with reduced Qg and TDDB, in accordance with various embodiments;
Fig. 2A is a schematic diagram of a cross-section of the LDMOS FET with reduced Qg and TDDB, in accordance with various embodiments;
Fig. 2B is a schematic diagram of a cross-section of the alternative LDMOS FET with reduced Qg and TDDB, in accordance with various embodiments; and
Fig. 3 is a schematic diagram of an LDMOS portion of a bipolar, CMOS, and LDMOS (BCDMOS) FET with reduced Qg and TDDB, in accordance with various embodiments.

### DETAILED DESCRIPTION OF EMBODIMENTS

Various embodiments set forth a LDMOS device with reduced Qg and TDDB.

In some embodiments, an apparatus for a LDMOS FET with reduced Qg and TDDB is provided. The apparatus includes a substrate comprising a first well having a first doping and a second well region having a second doping, a source formed in the first well, and a gate comprising an undoped block and a doped block. The undoped block is disposed at least partially on the source, first well, and second well. The doped block is disposed at least partially on the second well.

In further embodiments, a semiconductor device having an LDMOS FET with reduced Qg and TDDB is provided. The semiconductor device includes a source, a drain, and a gate disposed on a substrate, the gate comprising an undoped region and a doped region. The undoped region disposed at least partially on the source, and the doped region is disposed between the drain and source.

In further embodiments, an apparatus for an LDMOS with reduced Qg and TDDB is provided. The apparatus includes a substrate comprising a first well having a first doping and a second well region having a second doping, and a gate comprising an undoped block and a doped block, the undoped block disposed at least partially on the first well and the second well, wherein the doped block is disposed at least partially on the second well.

In the following description, for the purposes of explanation, numerous details are set forth to provide a thorough understanding of the described embodiments. It will be apparent to one skilled in the art, however, that other embodiments may be practiced without some of these details. Several embodiments are described herein, and while various features are ascribed to different embodiments, it should be appreciated that the features described with respect to one embodiment may be incorporated with other embodiments as well. By the same token, however, no single feature or features of any described embodiment should be considered essential to every embodiment of the invention, as other embodiments of the invention may omit such features.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Likewise, when an element is referred to herein as being a "layer," it is to be understood that the layer can be a single layer or include multiple layers. For example, a conductive layer may comprise multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, the methods and processes described herein may be described in a particular order for ease of description. However, it should be understood that, unless the context dictates otherwise, intervening processes may take place before and/or after any portion of the described process, and further various procedures may be reordered, added, and/or omitted in accordance with various embodiments.

Unless otherwise indicated, all numbers used herein to express quantities, dimensions, and so forth should be understood as being modified in all instances by the term "about." In this application, the use of the singular includes the plural unless specifically stated otherwise, and use of the terms "and" and "or" means "and/or" unless otherwise indicated. Moreover, the use of the terms "including" and "having," as well as other forms, such as "includes," "included," "has," "have," and "had," should be considered non-exclusive. Also, terms such as "element" or "component" encompass both elements and components comprising one unit and elements and components that comprise more than one unit, unless specifically stated otherwise.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

The FOM for LDMOS has traditionally been given as Qg * R_{DS(ON)}. Conventional approaches to improving the FOM exhibit high Qg. These may include drain extensions, surface implant processes, and split gate architectures. These approaches exhibit a high Qg. Moreover, when under HCI stress, TDDB and burnout have occurred in these designs.

In some embodiments, a proposed LDMOS architecture provides a reduced Qg and TDDB, including split gate architectures. By providing a region of gate polysilicon that does not receive heaving doping (e.g., n⁺ for heavy n-type doping, or p⁺ for heavy p-type doping) and does not receive a respective lightly-doped drain (LDD) implant (e.g., NLDD for n-type LDD, or PLDD for p-type LDD), the effective thickness of the gate oxide increases due to the polysilicon depletion effect. This in turn reduces Qg, and further reduces vertical electric field (which reduced TDDB). As a result, gate leakage current is reduced.

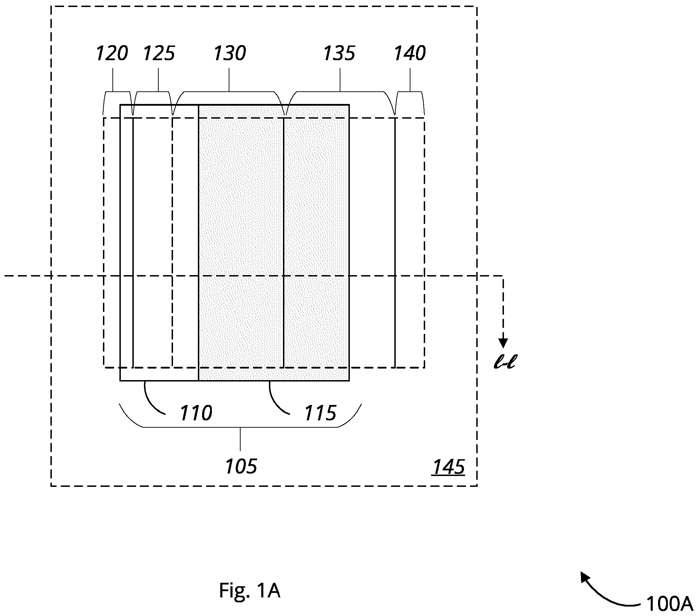

Fig. 1A is a schematic top view of a LDMOS FET 100A (hereinafter "LDMOS 100A") with reduced Qg and TDDB, in accordance with various embodiments. The LDMOS 100A includes a gate 105 having an undoped block 110 and doped block 115, source region 120, a first well 125, second well 130, trench isolation region 135, and drain region 140, and substrate 145. It should be noted that the various parts and components of LDMOS 100A are schematically illustrated in Fig. 1A, and that modifications to the various components and other arrangements of LDMOS 100A may be possible and in accordance with the various embodiments.

In various embodiments, the structures of the LDMOS 100A are disposed on the substrate 145. Accordingly, the substrate 145 may be a semiconductor substrate, such as, without limitation, bulk silicon. In some embodiments, the substrate 145 includes a lightly doped ("p⁻" or "n⁻") region. For example, in the case of an n-type LDMOS (NLDMOS), the substrate 145 may be lightly boron doped (e.g., p⁻), in which well regions may be formed (e.g., p-well and n-well). A well, accordingly, refers to a doped region formed within the substrate 145, which serves as the "bulk" or "body" of the LDMOS 100A, on (or in) which other parts of the device are formed, such as the gate 105, source region 120, trench isolation region 135, and drain region 140.

In the embodiments above, and further embodiments set forth below, boron and phosphorous are provided as non-limiting examples, and it is to be understood that in other embodiments, other dopants may be utilized. For example, suitable dopants may include, without limitation, pentavalent atoms (e.g., arsenic, phosphorous, antimony, bismuth, lithium, etc.) for n-type doping and trivalent atoms (e.g., indium, aluminum, gallium, boron, etc.) for p-type doping.

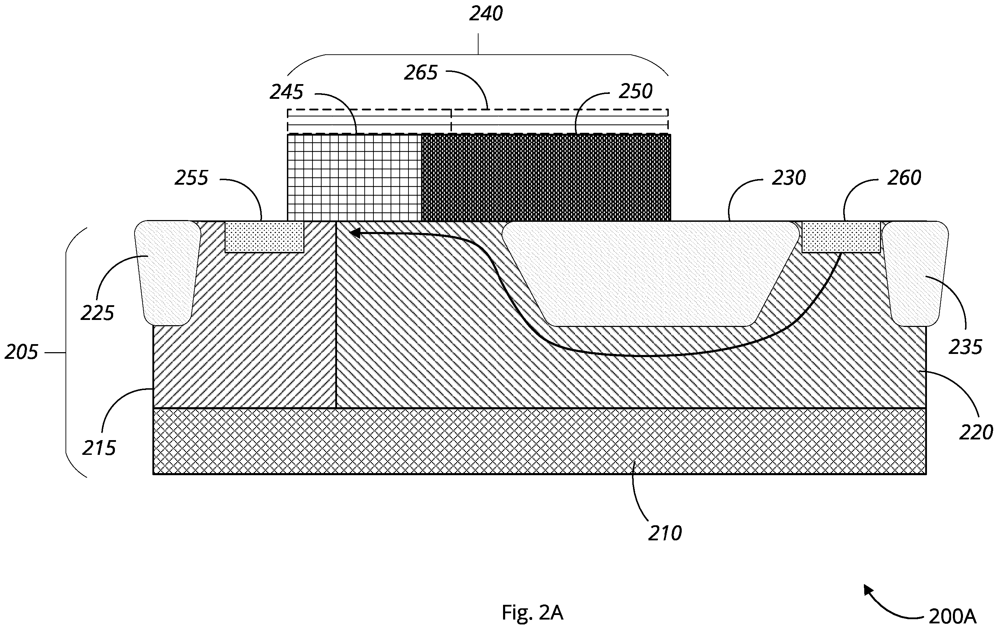

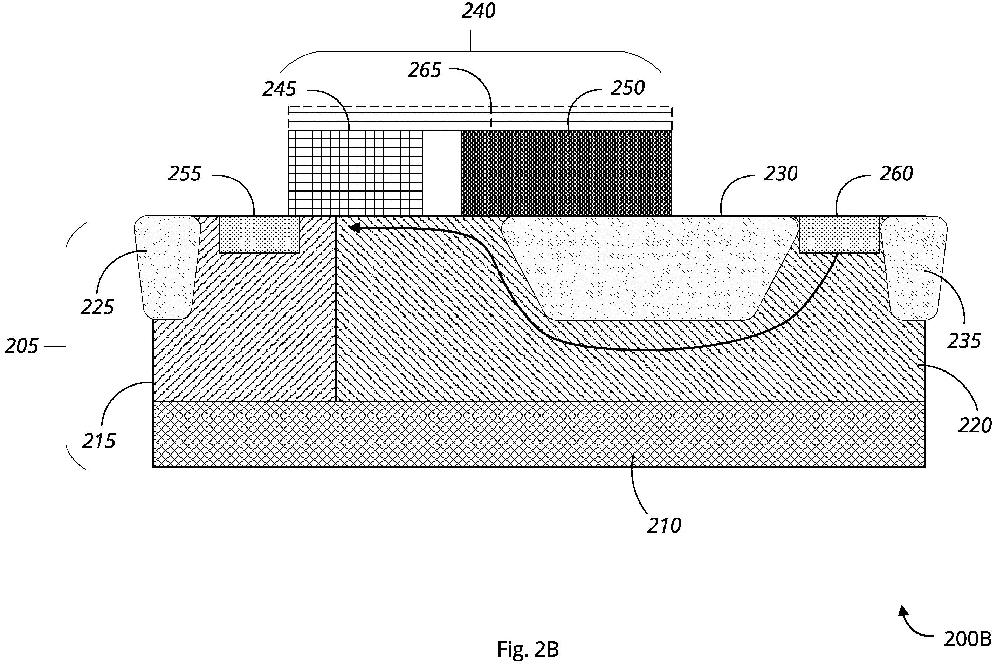

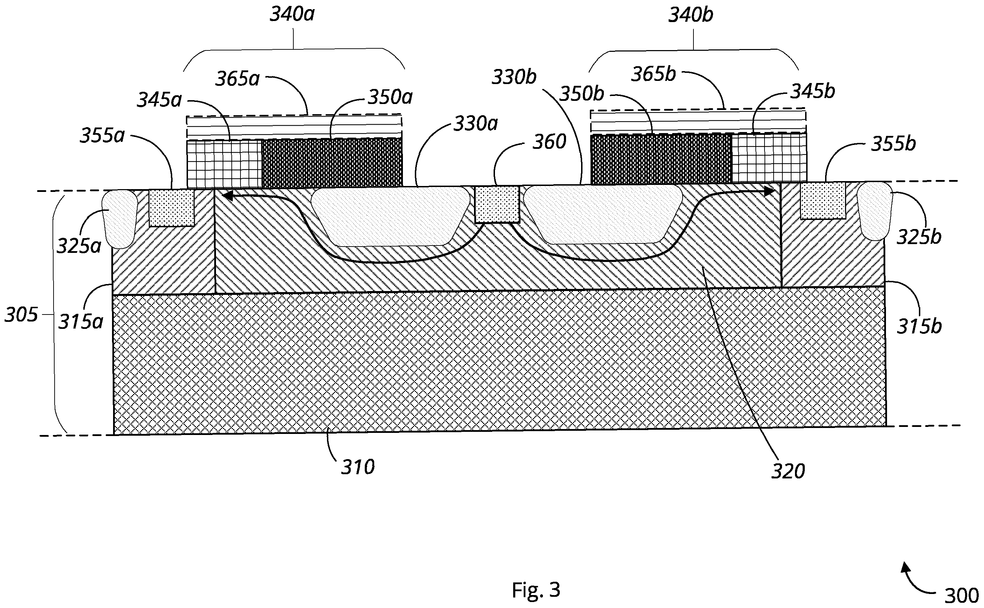

In various embodiments, the source region 120, first well 125, second well 130, trench isolation region 135, and drain region 140 may be formed within the substrate 145. Specifically, as will be discussed in greater detail below with respect to Figs. 2A, 2B & 3, the source region 120, first well 125, second well 130, trench isolation region 135, and drain region 140 may be formed via doping of different regions of the substrate 145.

In some embodiments, the substrate 145 may include one or more heavily doped ("p⁺" or "n⁺") regions, respectively doped with n-type (e.g., phosphorous) and p-type dopants (e.g., boron). In some examples, n⁺ or p⁺ regions may include the source region 120 and/or drain region 140. Other doped regions of the substrate 145 include a first well 125 having a first doping and second well 130 having a second doping different from the first. In some examples, the LDMOS 100A may be an NLDMOS. Accordingly, the first well 125 may have a p-type doping (e.g., a p-well), and the second well 130 may have a n-type doping (e.g., a n-well). Moreover, in an NLDMOS, the source and drain regions 120, 140 are formed as n⁺ doped regions of the substrate 145.

In various examples, the gate 105 is disposed on the substrate 145, over at least part of the source region 120, the first well 125, second well 130, and trench isolation region 135. In various examples, the gate 105 may be formed via an epitaxial process in which the gate may be grown or otherwise deposited on the substrate 145. Accordingly, in some examples, the gate 105 may be a polysilicon (e.g., polycrystalline silicon) gate, formed of a polysilicon material. In other examples, the gate 105 may be a partially- or fully-silicided poly silicon gate (as will be described in greater detail below with respect to Figs. 2A, 2B, & 3.

In various embodiments, the gate 105 includes an undoped block 110 and a doped block 115. As used herein, the term "block" refers to a piece of gate material (e.g., polysilicon, metal oxide, or other gate dielectric material) forming the structure gate, and/or a region of the gate 105. In some examples, the doped block 115 of the gate 105 may be doped via ion implantation. In some embodiments, the doped block 115 may have a LDD and/or heavy doping (e.g., n⁺, p⁺) implant applied, thereby receiving both a light doping and heavy doping. In some examples, the implant is an NLDD / n⁺ implant, the doped block 115 thereby receiving a light n-type doping and/or a heavy n-type (n⁺) doping. Accordingly, as used herein, "implant" refers to the process of doping via ion implantation into a respective structure. Thus, in some examples, the doped block 115 may receive both NLDD and n⁺ doping, forming a doped portion of the gate 105.

In various embodiments, the gate 105 further includes an undoped bloc k 110 which does not receive doping. For example, in some embodiments, an n⁺ and NLDD implant (or other implant) may not be applied to the undoped block 110 of the gate 105, thereby forming an undoped portion of the gate 105. An implant, as used herein, refers to a process of doping via masking and ion implantation into a structure, such as the doped block 115 of gate 105.

Thus, the gate 105 includes both an undoped portion 110 and doped portion 115. The undoped portion 110 of the gate 105 extends the effective thickness of the gate oxide due to the polysilicon depletion effect. In turn, Qg is reduced, and vertical electric fields are also reduced (which in turn mitigates TDDB). As a result, gate leakage current is also reduced.

In various embodiments, the source region 120 may be formed within the substrate 145, and disposed at least partially under the undoped block 110, and at least partially to the left side of the undoped block 110. The first well 125 is disposed directly adjacent to the source region 120 on a right side of the source region 120, and under the undoped block 110. The second well 130 is disposed directly adjacent to the first well 125 on a right side of the first well 125. The second well 130 is further disposed, at least partially, under the undoped block 110 and doped block 115 of the gate 105. In some examples, the second well 130 may be disposed under the doped block 115, but not the undoped block 110. In other words, the doped block 115 may be disposed on the second well 125 up to the border between the first well 125 and second well 130. The undoped block 110, in turn, may be disposed, at least partially, on the first well 125, but not the second well 130. In some examples, the trench isolation region 135 may be disposed directly adjacent to the second well 130, on a right side of the second well 130. The trench isolation region 135 may be disposed, at least partially, under the doped region of the gate (e.g., doped block 115). The drain region 140 may be disposed directly adjacent to the trench isolation region 135, on a right side of the trench isolation region 135.

Accordingly, in some embodiments, the source region 120 may be a heavily doped (e.g., n-type heavily doped (n⁺) or p-type heavily doped (p⁺)) region within the substrate, disposed on a first side of the undoped block 110 of the gate 105, and at least partially under the undoped region of the gate (e.g., undoped block 110). The source region 120 may, in some examples, be referred to interchangeably as the "source" or "source/drain" of the LDMOS 100A. In some further embodiments, the source region 120 may be formed as raised source / drain (RSD) structures. In some further embodiments, the source region 120 may be part of a fin (e.g., as in a FinFET device).

Similarly, the drain region 140 may be a heavily doped (e.g., n⁺ or p⁺) region within the substrate, disposed on a second side, opposite the first, (e.g., a right side of the doped block 115) of the gate 105. The drain region 140 may, in some examples, be referred to interchangeably as the "drain" or "drain/source" of the LDMOS 100A. In some further embodiments, the drain region 140, like source region 120, may be formed as raised source / drain (RSD) structures. In some further embodiments, the source region may be part of a fin (e.g., as in a FinFET device). The fin may be heavily doped, and formed as part of the drain (also referred to as "drain/source").

In various examples, the substrate 145 further includes trench isolation regions, such as the trench isolation regions 135. Trench isolation regions may be trenches formed in the substrate, and filled with an oxide material. In some examples, the trench isolation region 135 may be a shallow trench isolation (STI) region. In other examples, the trench isolation region 135 may be a deep trench isolation (DTI) region. Trench isolation regions are filled trench regions configured to mitigate leakage current between different components, in this example, electric field and/or leakage current between the source and drain regions 120, 140. It is known that STI structures can enhance HCI induced TDDB. Thus, in various embodiments, the undoped block 110 of the gate 105, and corresponding increase in effective thickness of the gate 105, reduces the effects of HCI induced TDDB.

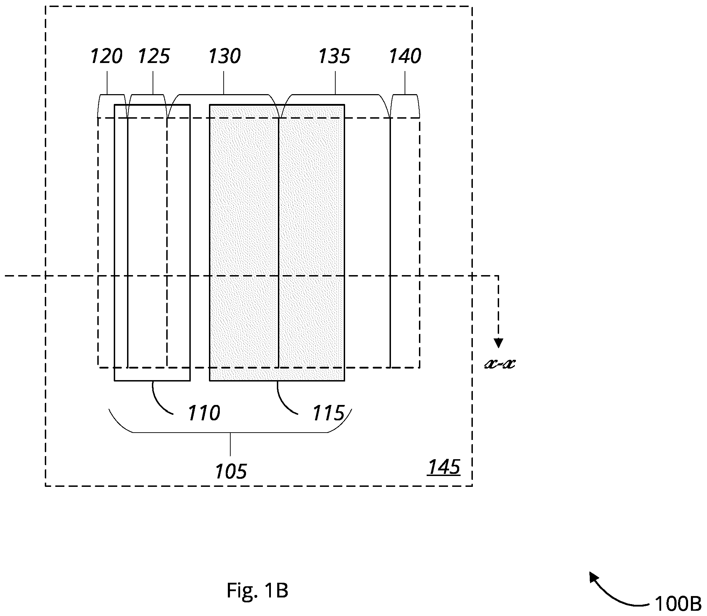

Fig. 1B is a schematic top view of an alternative configuration for an LDMOS FET 100B (hereinafter "LDMOS 100B") with reduced Qg and TDDB, in accordance with various embodiments. The LDMOS 100B includes a gate 105 having an undoped block 110 and doped block 115, source region 120, a first well 125, second well 130, trench isolation region 135, and drain region 140, and substrate 145. It should be noted that the various parts and components of LDMOS 100B are schematically illustrated in Fig. 1B, and that modifications to the various components and other arrangements of LDMOS 100B may be possible and in accordance with the various embodiments.

In contrast with LDMOS 100A of Fig. 1A, the gate 105 of LDMOS 100B is a split gate architecture, in which the structure of the gate is "split" into two separate gate structures (e.g., gate structures that are spaced apart on the surface of the substrate 145 and not in direct contact), as opposed to a single gate FET as shown in LDMOS 100A. In the embodiments depicted, the undoped block 110 is split (e.g., separated) from the doped block 115, forming a split gate. Accordingly, in some embodiments, a gap is present between the undoped block 110 and doped block 115, separating the undoped and doped blocks 110, 115 over the second well 130. Specifically, the undoped block 110 is disposed at least partially over the source region 120, first well 125, and at least partially over the second well 130.

Fig. 2A is a schematic diagram of a cross-section of the LDMOS 100A, 200A, taken across line *l*-*l*, in accordance with various embodiments. The sectional view of LDMOS 200A shows the different portions and structures described above, but obscured in the top view. Accordingly, LDMOS 200A includes a substrate 205, having an undoped/lightly doped region 210, a first well 215, second well 220, first trench isolation region 225, second trench isolation region 230, third trench isolation region 235, gate 240 having an undoped block 245 and doped block 250, cap 265, source region 255, and drain region 260. It should be noted that the various parts and components of LDMOS 200A are schematically illustrated in Fig. 2A, and that modifications to the various components and other arrangements of LDMOS 200A may be possible and in accordance with the various embodiments.

As shown in the cross-sectional view, the substrate 205 may include an undoped/lightly doped region 210 on which the first and second wells 215, 220 are formed. In various examples, the undoped/lightly doped region 210 of the substrate 205 may instead be lightly doped. For example, in an NLDMOS, the undoped/lightly doped region 205 is lightly boron doped (e.g., p-type). In various examples, the substrate 205 further includes a first well 215 and second well 220. In various examples, the first and second wells 215, 220 may be heavily doped regions of the substrate 205. For example, in an NLDMOS, the first well 215 may be a p-type doped (e.g., boron doped) "p-well," and the second well 220 may be a n-type doped (e.g., phosphorous doped) "n-well." In various examples, the substrate 205 further includes trench isolation regions, such as first through third trench isolation regions 225-235. Trench isolation regions may be trenches formed in the substrate, and filled with an oxide material. In some examples, one or more of the first, second, and third trench isolation regions 225-235 may be shallow trench isolation (STI) regions. In some examples, one or more of the first, second, and third trench isolation regions 225-235 may be deep trench isolation (DTI) regions.

As previously described with respect to Fig. 1A, the gate 240 may include an undoped block 245 and doped block 250. In some embodiments, the LDMOS 200A may be an NLDMOS, and a NLDD and/or n⁺ implant may be applied to the doped block 250, giving it one or more of a light n-type doping and heavy n-type doping. In other embodiments, such as a PLDMOS, a PLDD and/or p⁺ implant may be applied to the doped block 250. Accordingly, the doped block 250 may be region of the gate 240 to which NLDD/PLDD and/or n^{+/}p⁺ implantation is applied, and the undoped block 245 may be a region to which the implant is not applied. As previously described, the undoped and doped block 245, 250 may be part of the structure of the gate 240, and formed as blocks of dielectric material (or parts of the dielectric material forming the gate 240). In some examples, the undoped and doped blocks 245, 250 may be blocks (or regions of a block) of polysilicon forming the gate 240.

Accordingly, in various examples, the gate 240 may further include a cap 265. The cap 265 may extend over the full gate 240, or partially over the gate 240. In some examples, a partial cap 265 may cover the undoped block 245 and at least part of the doped block 250. The cap 265 may, in some examples, be a salicide (e.g., self-aligned silicide) and/or polycide cap 265 that is grown and/or deposited on the gate 240.

Fig. 2B is a schematic diagram of a cross-section of the LDMOS 100B, 200B, taken across line *x-x,* in accordance with various embodiments. As previously described above with respect to Fig. 1B, in contrast with LDMOS 200A, in the examples depicted, the gate 240 is a split gate in which undoped block 245 is split (e.g., separated) from the doped block 250, forming a split gate. Accordingly, in some embodiments, a gap is present between the undoped block 245 and doped block 250, the gap being formed over the second well 220. Specifically, the undoped block 245 is disposed at least partially over the source region 255, first well 215, and at least partially over the second well 220.

Fig. 3 is a schematic diagram of a cross-section of an LDMOS portion of a BCDMOS FET 300 (hereinafter "BCDMOS 300"), in accordance with various embodiments. The BCDMOS 300 includes a substrate 305, having an undoped/lightly doped region 310, a set of first wells 315a, 315b, a second well 320, a set of first trench isolation regions 325a, 325b, a set of second trench isolation region 330a, 330b, a first gate 340a having a first undoped block 345a and first doped block 350a, first and second caps 365a, 365b, a second gate 340b having a first undoped block 345a and first doped block 350a, a first source region 355a, second source region 355a, and drain region 360. It should be noted that the various parts and components of BCDMOS 300 are schematically illustrated in Fig. 3, and that modifications to the various components and other arrangements of BCDMOS 300 may be possible and in accordance with the various embodiments

Like the LDMOS 200A, the BCDMOS 300 may feature a continuous single gate (as opposed to a split gate). However, in contrast with LDMOS 200A, the BCDMOS 300 includes two gates (first gate 340a and second gate 340b). Each gate 340a, 340b includes a respective undoped block 345a, 345b and doped block 350a, 350b. The BCDMOS 300 may include two connected LDMOS devices sharing a drain region 360, where the LDMOS devices are flipped in orientation. For example, the first LDMOS may have a source-gate-drain configuration (e.g., from left-to-right, a first source region 355a, first gate 340a, followed by the drain region 360). The second LDMOS may have a drain-gate-source configuration (e.g., from left-to-right, drain region 360, second gate 340b, followed by the second source region 355b). Furthermore, the BCDMOS 300 may include the second well 320 may include two second trench isolation regions 330a, 330b disposed on either side of the drain region 360, separating the drain region 360 from the respective source regions 355a, 355b.

In various examples, the gates 340a, 340b may further include respective caps 365a, 365b. The first and second caps 365a, 365b may cover an entire respective gate 340a, 340b, or partially cover (e.g., extend partially over) a respective gate 340a, 340b. In some examples, a partial cap 365a, 365b may cover a respective undoped block 345a, 345b and at least part of a respective doped block 350a, 350b. The cap 365a, 365b may, in some examples, be a salicide (e.g., self-aligned silicide) and/or polycide that is grown and/or deposited on the respective gate 340a, 340b.

As depicted, the second gate 340b includes second undoped block 345b and doped block 350b. The second gate 340b may be in a flipped configuration from the first gate 340a, where the second doped block 350b is disposed on the left side, over the second well 320 and second trench isolation region 330b, and doped block 345b is disposed on the right side, disposed on the second well 320, first well 315b, and second source region 355b.

It is to be understood that in other embodiments, other gate configurations may be utilized. For example, in some embodiments, one or more of the gates 340a, 340b may be a split gate, in which the undoped block 345a, 345b and doped block 350a, 350b are separated, as previously described with respect to Figs. 1B & 2B. As previously described, in various embodiments, the gates 340a, 340b may be formed of polysilicon. In each of these configuration, the undoped blocks 345a, 345b of the respective gates 340a, 340b increases the effective thickness of the respective gate 340a, 340b, reducing Qg and HCI induced TDDB.

While some features and aspects have been described with respect to the embodiments, one skilled in the art will recognize that numerous modifications are possible. For example, the methods and processes described herein may be implemented using hardware components, custom integrated circuits (ICs), programmable logic, and/or any combination thereof. Further, while various methods and processes described herein may be described with respect to particular structural and/or functional components for ease of description, methods provided by various embodiments are not limited to any particular structural and/or functional architecture but instead can be implemented in any suitable hardware configuration. Similarly, while some functionality is ascribed to one or more system components, unless the context dictates otherwise, this functionality can be distributed among various other system components in accordance with the several embodiments.

Moreover, while the procedures of the methods and processes described herein are described in a particular order for ease of description, unless the context dictates otherwise, various procedures may be reordered, added, and/or omitted in accordance with various embodiments. Moreover, the procedures described with respect to one method or process may be incorporated within other described methods or processes; likewise, system components described according to a particular structural architecture and/or with respect to one system may be organized in alternative structural architectures and/or incorporated within other described systems. Hence, while various embodiments are described with or without some features for ease of description and to illustrate aspects of those embodiments, the various components and/or features described herein with respect to a particular embodiment can be substituted, added and/or subtracted from among other described embodiments, unless the context dictates otherwise. Consequently, although several embodiments are described above, it will be appreciated that the invention is intended to cover all modifications and equivalents within the scope of the following claims.

## Claims

1. An apparatus comprising:
a substrate (145, 205, 305) comprising a first well (125, 215, 315) having a first doping and a second well region (130, 220, 320) having a second doping;
a source (120, 255, 355) formed in the first well (125, 215, 315); and
a gate (105, 240, 340) comprising an undoped block (110, 245, 345) and a doped block (115, 250, 350), the undoped block (110, 245, 345) disposed at least partially on the source (120, 255, 355), first well (125, 215, 315), and second well (130, 220, 320), wherein the doped block (115, 250, 350) is disposed at least partially on the second well (130, 220, 320).

2. The apparatus of claim 1, wherein the gate (105, 240, 340) is a split gate, wherein the doped block (115, 250, 350) and undoped block (110, 245, 345) are separated.

3. The apparatus of claim 1 or 2, comprising at least one of the following features:
wherein the gate (105, 240, 340) is formed of polycrystalline silicon;
wherein the first doping is a p-type doping, and the second doping is an n-type doping;
wherein the source (120, 255, 355) is a heavily n-type doped region in the first well (125, 215, 315).

4. The apparatus of any of claims 1 to 3, wherein the doped block (115, 250, 350) has at least one of a light doping implant or heavy doping implant applied.

5. The apparatus of claim 4, comprising at least one of the following features:
wherein the doped block (115, 250, 350) has an n-type lightly doped drain implant and n-type heavy doping implant applied;
wherein the implant includes a light and heavy doping of a same type as the second doping.

6. The apparatus of any of claims 1 to 5, wherein the substrate (145, 205, 305) includes a shallow trench isolation region (135, 225, 230, 235, 325) formed in the second well (130, 220, 320), wherein the shallow trench isolation region (135, 225, 230, 235, 325) is disposed between a drain formed in the second well (130, 220, 320) and the source (120, 255, 355), wherein the doped block (115, 250, 350) is disposed at least partially on the shallow trench isolation region (135, 225, 230, 235, 325).

7. A semiconductor device comprising:
a source (120, 255, 355);
a drain (140, 260, 360); and
a gate (105, 240, 340) disposed on a substrate (145, 205, 305), the gate (105, 240, 340) comprising an undoped region and a doped region, the undoped region disposed at least partially on the source (120, 255, 355), wherein the doped region is disposed between the drain (140, 260, 360) and source (120, 255, 355).

8. The apparatus of claim 7, comprising at least one of the following features:
wherein the gate (105, 240, 340) is a split gate, wherein the doped region and undoped regions are separate respective blocks of dielectric material;
wherein the gate (105, 240, 340) is formed of polycrystalline silicon.

9. The apparatus of claim 7 or 8, wherein the doped block (115, 250, 350) has at least one of a light doping implant or heavy doping implant applied.

10. The apparatus of claim 9, wherein the doped block (115, 250, 350) has an n-type lightly doped drain implant and n-type heavy doping implant applied.

11. The apparatus of any of claims 7 to 10, wherein the substrate (145, 205, 305) includes a shallow trench isolation region (135, 225, 230, 235, 325) disposed between the drain (140, 260, 360) and source (120, 255, 355), wherein the doped block (115, 250, 350) is disposed at least partially on the shallow trench isolation region (135, 225, 230, 235, 325).

12. An apparatus comprising:
a substrate (145, 205, 305) comprising a first well (125, 215, 315) having a first doping and a second well region (130, 220, 320) having a second doping; and
a gate (105, 240, 340) comprising an undoped block (110, 245, 345) and a doped block (115, 250, 350), the undoped block (110, 245, 345) disposed at least partially on the first well (125, 215, 315) and the second well (130, 220, 320), wherein the doped block (115, 250, 350) is disposed at least partially on the second well (130, 220, 320).

13. The substrate (145, 205, 305) of claim 12, comprising at least one of the following features:
wherein the gate (105, 240, 340) is a split gate, wherein the doped block (115, 250, 350) and undoped block (110, 245, 345) are separated blocks of dielectric material;
wherein the gate (105, 240, 340) is formed of polycrystalline silicon.

14. The substrate (145, 205, 305) of claim 12 or 13, wherein the first doping is a p-type doping, and the second doping is an n-type doping.

15. The substrate (145, 205, 305) of claim 14, wherein the doped block (115, 250, 350) has at least one of an n-type lightly doped drain implant and an n-type heavy doping implant applied.
